(19) **Europäisches Patentamt**

**European Patent Office**

**Office européen des brevets**

(11) **EP 0 435 404 B1**

(12) **EUROPEAN PATENT SPECIFICATION**

(45) Date of publication and mention
of the grant of the patent:
**25.10.2000 Bulletin 2000/43**

(51) Int. Cl.⁷: **H03K 19/094**, H03K 19/0175

(21) Application number: **90203439.6**

(22) Date of filing: **19.12.1990**

(54) **Differential input bicmos buffer-inverters and gates**

BiCMOS-Pufferinverter und Gatter mit differentielem Eingang

Portes et tampons inverseurs biCMOS avec une entrée différentielle

(84) Designated Contracting States:
**DE FR GB IT**

(30) Priority: **28.12.1989 US 458217**

(43) Date of publication of application:
**03.07.1991 Bulletin 1991/27**

(73) Proprietor:
**Koninklijke Philips Electronics N.V.**
**5621 BA  Eindhoven (NL)**

(72) Inventors:
• **Burton, Edward**
  **NL-5656 AA  Eindhoven (NL)**

• **Fletcher, Thomas**
  **NL-5656 AA  Eindhoven (NL)**

(74) Representative:
**Strijland, Wilfred et al**
**INTERNATIONAAL OCTROOIBUREAU B.V.,**
**Prof. Holstlaan 6**
**5656 AA  Eindhoven (NL)**

(56) References cited:
**EP-A- 0 058 958**       **EP-A- 0 209 805**
**EP-A- 0 398 808**

**Description**

FIELD OF USE

The present invention relates to devices utilizing bipolar and field effect transistors (FETs). More particularly, the present invention relates to BICMOS buffers, inverters, and gates which utilize complementary inputs and provide increased output drive at a buffered output.

BACKGROUND ART

The new technology of BICMOS which utilizes both bipolar and CMOS transistors in a single device has been increasingly explored in the past few years. The advantage of BICMOS circuits over conventional CMOS or bipolar circuits is that the high speed characteristic of bipolar circuits can be obtained with an integration density and low power consumption characteristic of CMOS circuits.

Typical of BICMOS buffers, inverters and gates known in the art are the following patents and disclosures: U.S. Patent #4,558,234 to Suzuki et al.; U.S. Patent #4,638,186 to McLaughlin; U.S. Patent #4,649,294 to McLaughlin; U.S. Patent #4,733,110 to Hara et al.; EPO Publication 0212004; IBM TDB Vol. 29, #3, August 1986, p.1191; Japanese Patent applications 62-26691 to Miyaoka; 61-72904 to Ueno; and 60-117618 to Nakamura. Additional buffers, inverters and gates are disclosed in the following articles: Liang-Tsai Lin et al., "A 9100 Gate ECL/TTL Compatible BICMOS Gate Array", IEEE 1987 Custom Integrated Circuits Conference: pp. 190-194; P. Simon Bennett et al., "High Performance BIMOS Gate Arrrays with Embedded Configurable Static Memory", IEEE 1987 Custom Integrated Circuits Conference: pp.195-197; Yoji Nishio et al., "0.45ns 7K Hi-BICMOS Gate Array with Configurable 3-Port 4.6K SRAM", IEEE 1987 Custom Integrated Circuits Conference: pp.203-204; Chu et al., "A Comparison of CMOS circuit Techniques: Differential Cascode Voltage Switch Logic Versus Conventional Logic", IEEE Journal of Solid- State Circuits: Vol Sc-22, No. 4 (Aug. 1987); Masaharu Kubo, et al., "Perspective on BICMOS VLSI's", IEEE Journal of Solid-State Circuits; Vol. 23, No. 1 (Feb. 1988); Shih-Lien Lu, "Implementation of Iterative Networks with CMOS Differential Logic" IEEE Journal of Solid-State Circuits: Vol. 23, No. 4 (Aug. 1988).

EP-A-0-058 958 (TOKYO SHIBAURA) shows BICMOS logic gates without differential inputs. EP-A-0 209 805 also shows BICMOS logic gates without differential inputs.

Common to almost all of the above disclosures is that either a single input, or non-differential multiple inputs are utilized as inputs into the circuits, or that a non-synchronous differential input is utilized.

It is an object of the invention to provide differential input, differential output BICMOS buffers, inverters and gates.

It is yet another object of the invention to provide differential input, differential output BICMOS buffers and inverters which are cascadable.

It is still another object of the invention to provide high drive differential input buffers and inverters with only one transistor delay.

To meet the objects of the invention, there is provided an electronic circuit comprising: input means with a first output terminal for providing a first logic output signal and a second output terminal for providing a second logic output signal, the first and the second logic output signals being complementary; a first bipolar transistor having a base coupled to the first output terminal of the input means, a collector coupled to a first voltage reference rail, and an emitter; a second bipolar transistor, having a collector coupled to the emitter of the first bipolar transistor, an emitter coupled to a second voltage reference rail, and an base; a first MOS transistor, having a drain, a source coupled to the base of the second bipolar transistor, and a gate coupled to the second output terminal of the input means; and a first input terminal for receiving a first logic input signal and a second input terminal for receiving a second logic input signal, the first and the second logic input signals being complementary.

In the embodiments, a circuit output is taken from a node at the emitter of the first bipolar transistor and the collector of the second bipolar transistor. Also, in addition, the first bipolar transistor may be coupled to a pMOS device with the collector connected to the source, and the emitter connected to the drain. The pMOS device acts to pull up the output voltage of the circuit from the voltage provided at the emitter of the first bipolar transistor to the voltage of the high voltage rail. Where the pMOS device is provided, the circuit is a cascadable circuit in that voltage drive at the output is not decreased by one Vbe for each stage.

Additional embodiments include the aforementioned circuitry plus duplicative circuitry which is arranged such that the noninverted input signal is received at the gate electrodes and bases of transistors corresponding to transistors where the inverted input signal is received by the aforementioned circuitry, and vice versa. In most of these embodiments, a complementary output is obtained, with the noninverting output signal obtained from the emitter of a bipolar transistor of the "original" circuit, and the inverting output signal obtained from the emitter of a bipolar transistor of the duplicative circuit.

In accord with another aspect of the invention, npn transistors can be replaced with pnp tranistors; in which case the polarities of the nMOS and pMOS devices are reversed along with the polarities of the voltage rails. If desired, where duplicative circuitry is employed, the duplicative circuitry can employ transistors of opposite polarity to the original circuitry.

Additional objects and advantages of the invention will become evident upon reference to the detailed description in conjunction with the provided drawings.

BRIEF DESCRIPTION OF THE DRAWINGS

Figure 1 is a circuit diagram of a complementary inputs BICMOS buffer having complementary outputs.
Figure 2 is a circuit diagram of a cascadable complementary inputs, complementary outputs BICMOS buffer/inverter;
Figure 3 is a circuit diagram of another cascadable complementary inputs, complementary outputs BICMOS buffer/inverter;
Figures 4a and 4b are circuit diagrams of complementary two value input BICMOS gates having a single output (OR/NAND) and complementary outputs (OR/NAND, NOR/AND) respectively; and
Figure 5 is a circuit diagram of a complementary two value input BICMOS gate having two single ended outputs.

DETAILED DESCRIPTION OF THE PREFERRED EMBODIMENTS

Before describing the circuits shown in the Figures, it should be understood that for purposes of this application, the term "BICMOS" is used in its broadest sense to refer to circuits having both bipolar transistors and FETs, regardless of whether MOSFETs or other types of IGFETs are used or whether both p-channel and n-channel type MOS transistors are utilized in a single circuit. In fact, any description of a transistor as a MOS transistor is intended to be understood in its broadest sense to include other types of IGFETs and not to be limited to metalgate FETs. Also, it should be understood that while the circuits are described as preferably including npn bipolar transistors, if the polarities of the bipolar and MOS transistors are reversed, equivalent functional circuits are obtained. Further, it will be appreciated that while "inputs" and "outputs" to and from the circuit are described, little distinction is provided regarding whether the inputs or outputs are signals or nodes, as those skilled in the art will readily appreciate whether a signal or node is being described.

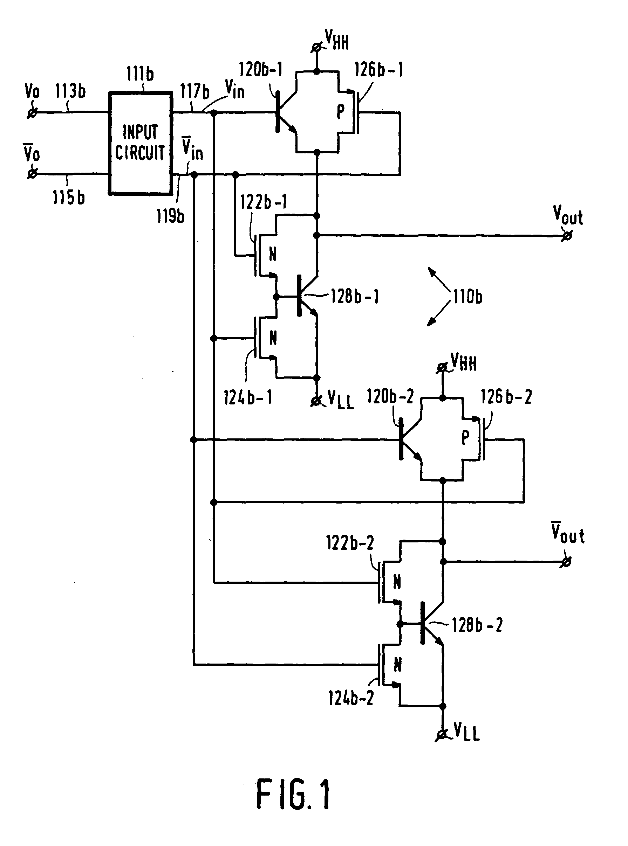

Figure 1 provides a differential input buffer. Buffer 110b receives complementary input signals ($V_{in}$, $\overline{V}_{in}$) from input circuit 111b. Buffer 110b includes npn bipolar transisistors 120b-1 and 128b-1, and MOS transistors 122b-1 and 124b-1. Transistor 126b-1 has its source connected to the collector of transistor 120b-1, its drain connected to the emitter of transistor 120b-1, and its gate electrode connected to the inverting input $\overline{V}_{in}$. When input $V_{in}$ is high and input $\overline{V}_{in}$ low, bipolar

transistor 120b-1 turns on quickly, while pMOS transistor 126b-1 turns on a little more slowly. Because the source of transistor 126b-1 is connected to the high voltage rail, transistor 126b-1 pulls the voltage at its drain from $V_{in}$ - $V_{be}$ (which is the voltage at the emitter of transistor 120b-1 when the $V_{in}$ input is at the high input voltage $V_{in}$) all the way up to $V_{HH}$. Because the output voltage swings all the way up to $V_{HH}$, the circuit of Figure 1 can be used in series without a progressive degradation in the high output voltage.

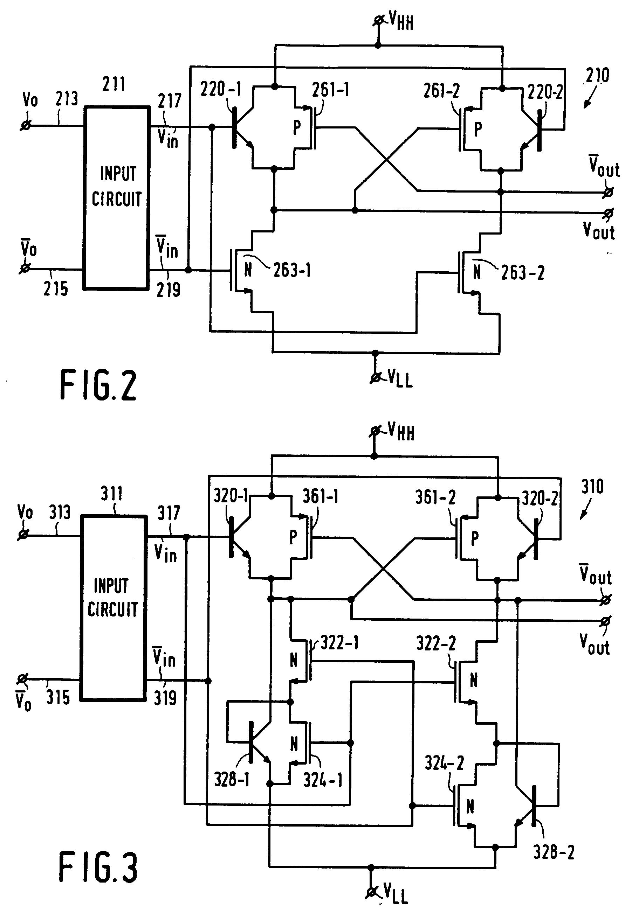

Turning to Figure 2, an embodiment of a differential buffer/inverter is provided. Again an input circuit 211 is shown receiving the $V_0$ input 213, and the $\overline{V}_0$ input 215, and providing complementary outputs over lines 217 and 219 with the noninverting signal $V_{in}$, and the inverting signal $\overline{V}_{in}$. The $V_{in}$ signal from circuit 211 serves as the noninverting input into buffer 210 and is fed to the base of bipolar transistor 220-1. Bipolar transistor 220-1 has a collector coupled to the high voltage rail, and an emitter coupled to the noninverting output of the buffer circuit. Coupled to transistor 220-1 is a pMOS transistor 261-1 with its source coupled to the collector of transistor 220-1 and its chain coupled for the emitter of transistor 220-1. Also coupled to the emitter of transistor 220-1 is the drain of nMOS transistor 263-1. Transistor 263-1 is provided with the inverting input $\overline{V}_{in}$ at its gate electrode, and has its source coupled to the low voltage rail.

Buffer 210 also includes another set (i.e. duplicative set) of transistors, including bipolar transistor 220-2, pMOS transistor 261-2, and nMOS transistor 263-2. The base of transistor 220-2 is coupled to the inverted input $\overline{V}_{in}$, while the collector of transistor 220-2 is coupled to the high voltage rail, and the emitter is coupled to the inverting output $\overline{V}_{out}$. P-channnel type MOS transistor 261-2 is coupled to bipolar transistor 220-2 with its source coupled to the collector of transistor 220-2 and its drain coupled to the emitter of transistor 220-2. The gate electrode of transistor 261-2 is coupled to the emitter of transistor 220-1 and the drain of transistor 261-1, while the emitter of transistor 220-2 and drain of transistor 261-2 are coupled to the gate electrode of transistor 261-1. Transistor 263-2 is provided with input $V_{in}$ at its gate. The drain of transistor 263-2 is coupled to the emitter of transistor 220-2, and the source of transistor 263-2 is coupled to the low voltage rail.

With the provided arrangement, when $V_{in}$ is high ($\overline{V}_{in}$ low), transistor 220-1 turns on quickly and pulls the noninverting output $V_{out}$ to $V_{in}$ - $V_{be}$. similarly, transistor 263-2 turns on, pulling its drain, and the gate electrode of pMOS transistor 261-1 to $V_{LL}$. Thus, pMOS transistor 261-1 turns on and pulls output $V_{out}$ up to $V_{HH}$, much in the same way as described above with reference to Figure 1. Also, with $V_{in}$ high, as aforementioned, transistor 263-2 is turned on, pulling its drain and hence the inverting output $\overline{V}_{out}$ of the complementary output low to the voltage $V_{LL}$ at its source. When $V_{in}$ is high, the inverting signal $\overline{V}_{in}$ applied to the base of transistor 220-2 and the gate electrode of transistor 263-1 is low and turns transistors 220-2 and transistor 263-1 off. with transistor 220-2 off, the inverting output voltage $\overline{V}_{out}$ at the emitter of transistor 220-2 is tree to be controlled by transitor 263-2. Similarly, with transistor 263-1 off, the noninverting output voltage $V_{out}$ at the drain of transistor 263-1 is free to be controlled by transistors 220-1 and 261-1. It is also noted that with $V_{in}$ high, and the voltage at the drain of transistor 261-1 high, transistor 261-2 is off and does not try to pull the voltage high at the inverting output of the circuit.

When $V_{in}$ goes low and $\overline{V}_{in}$ goes high, the voltage at the base of transistor 220-1 and gate electrode of transistor 263-2 go low turning off those transistors, while the voltage at the base of transistor 220-2 and gate electrode of transistor 263-1 go high, turning on those transistors. With transistor 220-2 on, and transistor 263-2 off, the voltage at the emitter of transistor 220-2 goes to $V_{in} - V_{be}$, while with transistor 220-1 off and transistor 263-1 on, the voltage at the emitter of transistor 220-1 (i.e. at the drain of transistor 263-1) goes to $V_{LL}$. Since the drain of transistor 261-2 is coupled to the emitter of transistor 220-2, transistor 261-2 turns on and pulls the voltage at the emitter of transistor 220-2 (and hence at the inverting output $\overline{V}_{out}$) up to $V_{HH}$. Thus, the outputs $V_{out}$ and $\overline{V}_{out}$ are inverted from when $V_{in}$ is high and $\overline{V}_{in}$ is low.

The buffer/inverter embodiment of Figure 3 combines aspects of the buffer/inverters of Figures 1 and 2, and is hereinafter described with like parts indicated by numbers one hundred and two hundred removed from their counterparts. The buffer/inverter 310 of Figure 3 includes the bipolar transistors 320-1 and 320-2 whose bases are coupled to the complementary inputs, and pMOS transistors 361-1 and 361-2 which are coupled to the bipolar transistors and which provide the same features discussed above with reference to Figure 2. Further, buffer 310 has additional npn bipolar transistors 328-1 and 328-2, and additional nMOS transistors 322-1, 322-2, and 324-1, and 324-2.

When $V_{in}$ goes high ($\overline{V}_{in}$ low), bipolar transistor 320-1 turns on and bipolar transistor 320-2 turns off, MOS transistors 324-1 and 322-2 turn on, and MOS transistors 322-1 and 324-2 turn off. As a result of MOS transistor 324-1 turning on, bipolar transistor 328-1 is off. With bipolar transistor 328-1 off and bipolar transistor 320-1 on, the noninverting output $V_{out}$ is brought high to $V_{in} - V_{be}$. Also, with MOS transistor 322-2 on and MOS transistor 324-2 off, bipolar transistor 328-2 is turned on. With bipolar transistor 328-2 on and bipolar transistor 320-2 off, the inverting output $\overline{V}_{out}$ is brought low to $V_{LL} + V_{be}$. With the voltage at the collector of transistor 328-2 coupled to the gate electrode of pMOS transistor 361-1 and being low, pMOS transistor 361-1 turns on and boosts the noninverting output $V_{out}$ up to $V_{HH}$. Similarly, the high voltage output of $V_{out}$ is coupled to the gate of pMOS transistor 361-2 thereby keeping transistor 361-2 off and the voltage at the inverting out-

put $\overline{V}_{out}$ low.

When the polarities of $V_{in}$ and $\overline{V}_{in}$ switch, those transistors which were on turn off and vice versa. Thus, bipolar transistor 328-1 pulls the noninverting output $V_{out}$ low, while bipolar transistor 320-2, and then pMOS tranistor 361-2 pulls the inverting output $\overline{V}_{out}$ high.

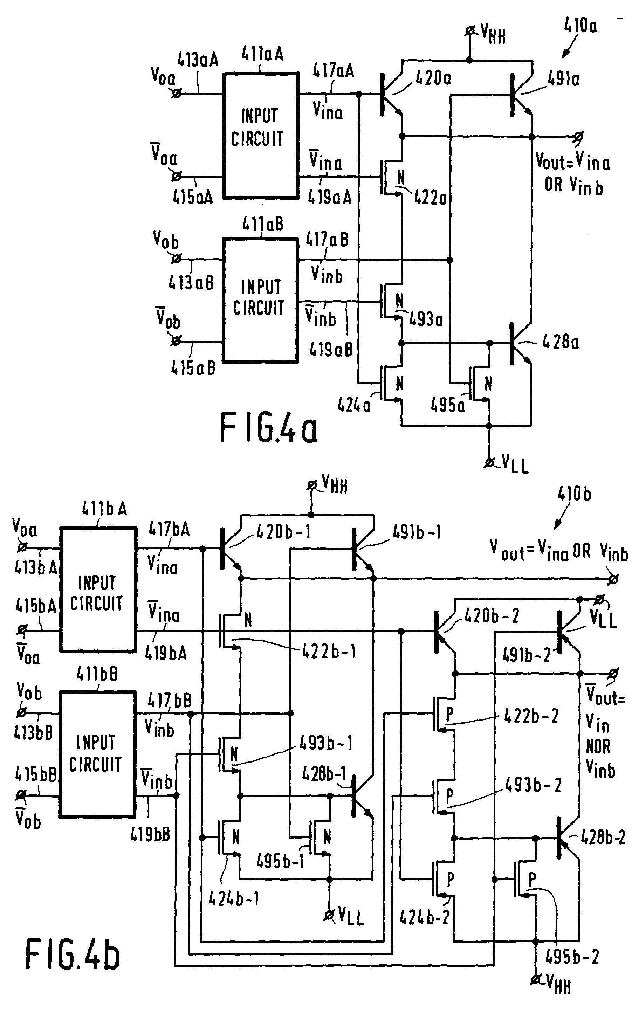

Before turning to Figures 4a and 4b, it should be appreciated that the buffers of Figures 1, 2 and 3 are all candidates for cascading; i.e. the complementary output of each may be fed as a differential input to any other differential input buffer. Among other reasons, cascading of buffers is desirable for providing an extremely fast delay line, with taps taken from the output of each stage. In such a situation it is preferable that each of the cascaded buffers be identical. Also, increased drive is obtained by cascading buffers in a "tree" arrangement, with the outputs of a first buffer being fed as inputs to a plurality of parallel buffers.

Turning to Figure 4a, OR/NAND gate 410a which is related to the buffer of Figure 1 is provided. Thus, npn bipolar transistors 420a and 428a as well as nMOS transistors 422a and 424a are provided. The collector of transistor 420a is coupled to the high voltage rail, the base is coupled to the input signal $V_{ina}$, and the emitter is coupled to the collector of transistor 428a. The emitter of transistor 428a is coupled to the low voltage rail, while the base is coupled to the drain of transistor 424a and the source of transistor 422a (via transistor 493a). The gates of transistors 422a and 424a are respectively coupled to the inverting and noninverting inputs $\overline{V}_{ina}$ and $V_{ina}$. OR gate 410a includes a bipolar transistor 491a, and two nMOS transistors 493a and 495a. Bipolar transistor 491a is coupled in parallel with transistor 420a, except that its base is coupled to the noninverting input $V_{inb}$ of a second complementary input. MOS transistor 493a is provided with its gate electrode coupled to the inverting input $\overline{V}_{inb}$, and with a drain coupled to the emitter of transistor 420a (via transistor 422a) and a source coupled to the drain of MOS transistor 424a. MOS transistor 495a is coupled in parallel with MOS transistor 424a, except that its gate is coupled to the noninverting $V_{inb}$ input.

If either the $V_{ina}$ and/or $V_{inb}$ inputs go high, one or both of transistors 420a and 491a turn on, and one or both of transistors 424a and 495a also turn on. Also, one or both of transistors 422a and 493a turn off, and bipolar transistor 428a is off, as the voltage at the base thereof is brought to $V_{LL}$ by either transistor 424a or 495a. In such a state, and with bipolar transistor 428a off, the output voltage $V_{out}$ goes high as the output voltage follows the emitter of one of transistors 420a and 491a. Similarly, if both the $V_{ina}$ and $V_{inb}$ inputs go low, transistors 420a, 491a, 424a, and 495a turn off, while transistors 493a and 422a turn on. With transistors 491a and 424a off, and transistors 493a and 422a on, bipolar transistor 428a turns on. With transistor 428a on, and transistors 420a and 491a off, the output $V_{out}$ is

pulled low.

It will be appreciated by those skilled in the art that OR gate 410a functions equivalently as a NAND gate in accord with DeMorgan's theorem by reversing the $V_{ina}$ input with the $\overline{V}_{ina}$ input, and the $V_{inb}$ input with the $\overline{V}_{inb}$ input.

A complementary output embodiment of the OR/NAND gate of Figure 4a is seen in Figure 4b where differential inputs $V_{ina}$, $\overline{V}_{ina}$, and $V_{inb}$, $\overline{V}_{inb}$ are provided on lines 417bA, 419bA, and 417bB and 419bB, and npn transistors 420b-1, 428b-1 and 491b-1 and nMOS transistors 422b-1, 424b-1, 493b-1, and 495b-1 function identically as their equivalents in Figure 4a to provide an OR/NAND function at the non-inverted output $V_{out}$. In addition, pnp transistors 420b-2, 428b-2, and 491b-2, and pMOS transistors 422b-2, 424b-2, 493b-2 and 495b-2 are provided and produce a NOR/AND output at the inverted output $\overline{V}_{out}$ of the complementary output. As will readily be appreciated, the pnp and pMOS transistors of the -2 section of the circuit are arranged identically to the npn and nMOS transistors of the -1 stage, except that the polarity of the inputs 417bA, 419bA, 417bB and 419bB, and the polarity of the voltage rails are reversed.

With the arrangement of Figure 4b, when one (or both) of $V_{ina}$ and $V_{inb}$ are high, one or both of $\overline{V}_{ina}$ and $\overline{V}_{inb}$ are low, and therefore, one or both of pnp transistors 420b-2, and 491b-2 (and correspondingly pMOS transistors 424b-2 and 495b-2) are turned on. With one or both of transistors 420b-2 and 491b-2 on, the inverted output $\overline{V}_{out}$ is pulled low (i.e. to $V_{in} + V_{be}$). Also, with one or both of transistors 424b-2 and 495b-2 on, the voltage at the base of transistor 428b-2 is brought high, and transistor 428b-2 is kept off such that it does not attempt to pull the voltage at the inverted output high. Conversely, if both $V_{ina}$ and $V_{inb}$ are low, both $\overline{V}_{ina}$ and $\overline{V}_{inb}$ are high, and pnp transistors 420b-2, 491b-2 and pMOS transistors 424b-2 and 495b-2 turn off, while pMOS transistors 422b-2 and 493b-2 turn on. With transistors 422b-2 and 493b-2 on, and 424b-2 and 495b-2 off, pnp transistor 428b-2 turns on. With pnp transistor 428b-2 on, and transistors 420b-2 and 491b-2 off, the inverted output $\overline{V}_{out}$ is pulled high. It is therefore seen that $\overline{V}_{out}$ is high only when $V_{ina}$ and $V_{inb}$ are low, and is low when either $V_{ina}$ or $V_{inb}$ is high; a classical NOR gate. As with the noninverted output which is changed from an OR function to a NAND function, by reversing the $V_{ina}$ and $\overline{V}_{ina}$ inputs 417bA and 419bA and $V_{inb}$ and $\overline{V}_{inb}$ inputs 417bB and 419bB, the inverted output $\overline{V}_{out}$ is changed from a NOR to an AND function with such a reversal.

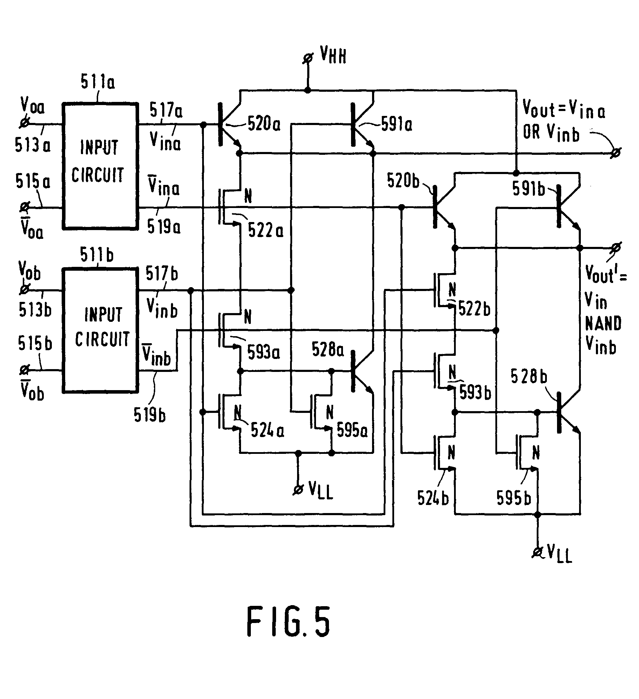

The logic gate of Figure 5 incorporates the circuitry of Figure 4a, along with duplicative circuitry which receives inverted inputs and which provides a second single ended output $V_{out'}$. The second single ended output $V_{out'}$ does not together with the first output $V_{out}$ provide a complementary output, as the second single ended output is not the inverse of the first single ended output.

As seen in Figure 5, the OR gate of Figure 4a is set forth with bipolar transistors 520a, 528a, and 591a, and with nMOS transistors 522a, 524a, 593a, and 595a. Also, duplicative bipolar transistors 520b, 528b, and 591b, and nMOS transistors 522b, 524b, 593b, and 595b are provided. As indicated above in the discussion regarding Figure 4a, an OR function is provided at the emitters of transistors 520a and 591a. Also, as indicated above in the discussion regarding Figure 4b, and the ability to change an OR into a NAND gate by reversing the inputs, it will be appreciated that a NAND function is provided at the emitters of transistors 520b and 591b, as the voltage $V_{out'}$ only goes low when both $V_{ina}$ and $V_{inb}$ are both high.

There has been described and illustrated herein complementary input BiCMOS buffer, inverters, and gates. While particular embodiments have been described, it is not intended that the invention be limited thereto as it is intended that the invention be broad in scope as the art will allow. Thus, for example, while nMOS transistors were used in most of the buffer and inverter embodiments to cause the base at the lower bipolar transistor of the two bipolar transistor arrangement to quickly reach the voltage of the low voltage rail (i.e. a hard pull of the base), it will be appreciated that a resistor could be substituted for that transistor. Alternatively, that transistor can be eliminated entirely from the circuit, although current leakage could result. Also, while a two complementary input OR/NAND (and NOR/AND) gate was shown, it will be appreciated that gates having as many complementary inputs as desired can be constructed by providing additional bipolar transistors with bases connected to additional (e.g. "$V_{inc}$" and "$V_{ind}$" inputs) in parallel with the bipolar transistors having the $V_{ina}$ and $V_{inb}$ input signals connected to their bases, and by providing additional MOS transistors with inverting $\overline{V}_{inc}$ and $\overline{V}_{ind}$ gate inputs in series with the MOS transistors having the $\overline{V}_{ina}$ and $\overline{V}_{inb}$ inputs to their gates, and further by providing additional MOS transistors with $V_{inc}$ and $V_{ind}$ gate inputs in parallel with the parallel MOS transistors with $V_{ina}$ and $V_{inb}$ gate inputs. Further, while use of npn bipolar transistors was disclosed in conjunction with advantageous location of nMOS and pMOS transistors, it will be appreciated that pnp bipolar transistors as well as substitution of pMOS for nMOS transistors and vice versa could be effectively utilized with minor changes which could be apparent to those skilled in the art. Therefore, it will be appreciated by those skilled in the art that yet other modifications could be made without deviating from its spirit and scope as so claimed.

**Claims**

1. An electronic circuit comprising: input means (311) with a first output terminal (Vin) for providing a first logic output signal (Vin), and a second output termi-

nal ($\overline{V}$in) for providing a second logic output signal ($\overline{V}$in), the first and the second logic output signals (Vin,$\overline{V}$in) being complementary; a first bipolar transistor (320-1) having a base coupled to the first output terminal (Vin) of the input means (311), a collector coupled to a first voltage reference rail ($V_{HH}$), and an emitter; a second bipolar transistor (328-1), having a collector coupled to the emitter of the first bipolar transistor (320-1), an emitter coupled to a second voltage reference rail ($V_{LL}$), and an base; a first MOS transistor (322-1), having a drain, a source coupled to the base of the second bipolar transistor (328-1), and a gate coupled to the second output terminal ($\overline{V}$in) of the input means (311), characterized in that the input means (311) further comprises a first input terminal (Vo) for receiving a first logic input signal (Vo) and a second input terminal ($\overline{V}$o) for receiving a second logic input signal ($\overline{V}$o), the first and the second logic input signals (Vo,$\overline{V}$o) being complementary.

2. A circuit as in claim 1, characterized in that the drain of the first MOS transistor (322-1) is coupled to the emitter of the first bipolar transistor (320-1).

3. A circuit as in claim 2, further comprising:

a third bipolar transistor (320-2) having a base coupled for the second output terminal ($\overline{V}_{in}$), a collector coupled to the first rail ($V_{HH}$), and an emitter;
a fourth bipolar transistor (328-2) having a base, a collector coupled to the emitter of the third bipolar transistor (320-2), and an emitter coupled to the second rail ($V_{LL}$);
a second MOS transistor (322-2) having a gate electrode coupled to the first output terminal ($V_{in}$), a drain coupled to the emitter of the third bipolar transistor (320-2), and a source coupled to the base of the fourth bipolar transistor (328-2), the first and second MOS transistors being of a first MOS type;
a third MOS transistor (361-1), having a gate electrode coupled to an inventing output terminal ($\overline{V}_{out}$) of the electric circuit, a source coupled to the first rail ($V_{HH}$), and a drain coupled to the emitter of the first bipolar transistor (320-1); and
a fourth MOS transistor (361-2) having a gate electrode coupled to a noninventing output terminal ($V_{out}$) of the electric circuit, a source coupled to the first rail ($V_{HH}$), and a drain coupled to the emitter of the third bipolar transistor (320-2), the third and fourth MOS transistors being of a second MOS type opposite to the first MOS type, the noninventing output terminal ($V_{out}$) and the inventing output terminal ($\overline{V}_{out}$) of the electronic circuit being coupled respectively for the emitters of the first (320-1) and third bipolar transistors.

4. A circuit as in claim 3 wherein the bipolar transistors (320-1, 320-2, 328-1, 328-2) are of a first bipolar type, the first MOS type is nMOS when the first bipolar type is npn, and the first MOS type is pMOS when the first bipolar type is pnp.

5. A circuit as in claim 4 further comprising:

a fifth MOS transistor (324-1) having a gate electrode responsive to the noninverting input ($V_0$), a drain coupled to the source of the first MOS transistor (322-1), and a source coupled to the second rail ($V_{LL}$); and
a sixth MOS transistor (324-2) having a gate coupled to the first output terminal ($V_{in}$), a drain coupled to the source of the second MOS transistor (322-2), and a source coupled to the second rail ($V_{LL}$), the fifth and sixth MOS transistors being of the first MOS type.

6. A circuit as in claim 5, characterized in that the gate of the third MOS transistor (361-1) is coupled to the source of the third bipolar transistor (320-2), the gate of the fourth MOS-transistor (361-2) is coupled to the source of the first bipolar transistor (320-1), the gates of the first (322-1) and the sixth (324-2) MOS transistors are coupled to the base of the third bipolar transistor (320-2); and the gates of the third (322-2) and the fifth (324-1) MOS transistors are coupled to the base of the first bipolar transistor (320-1).

7. A circuit as in claim 6 wherein the bipolar transistors (320-1, 320-2, 328-1, 328-2) are of a first bipolar type, the first MOS type is nMOS when the first bipolar type is npn, and the first MOS type is pMOS when the first bipolar type is pnp.

8. A circuit as in claim 1 comprising: second input means (411aB) with a third output terminal (Vinb) for providing a third logic output signal (Vinb), and a fourth output terminal ($\overline{V}$inb) for providing a fourth logic output signal ($\overline{V}$inb), the third and the fourth logic output signals (Vinb,$\overline{V}$inb) being complementary; a third input terminal (Vob) for receiving a third logic input signal (Vob) and a fourth input terminal ($\overline{V}$ob) for receiving a fourth logic input signal ($\overline{V}$o), the third and the fourth logic input signals (Vob,$\overline{V}$ob) being complementary; a noninverting output (Vout) coupled to the emitter of the first bipolar transistor (420a); a third bipolar transistor (491a) having a base coupled to the third output terminal (Vinb), a collector coupled to the collector of the first bipolar transistor (420a), and an emitter coupled to the emitter of the first bipolar transistor (420a); a second MOS transistor (422a) having a gate coupled to the second output terminal ($\overline{V}$ina), a drain coupled to the emitter of the first bipolar transistor (420a), and a source; and that the gate of the first MOS transistor (493a) is coupled to the fourth output terminal ($\overline{V}$inb), and the drain of the first MOS transistor (493a) is coupled to the source of the second MOS transistor (422a).

9. A circuit as in claim 8 further comprising:

a third MOS transistor (424a) having a gate electrode coupled to the first noninverting output terminal ($V_{ina}$) input ($V_{oa}$), a drain coupled to the base of the second bipolar transistor (428a), and a source coupled to the second rail (VLL); and
a fourth MOS transistor (495a) having a gate electrode coupled to the third output terminal ($V_{inb}$), a drain coupled to the base of the second bipolar transistor (428a), and a source coupled to the second rail ($V_{LL}$).

10. A circuit as in claim 9 wherein the MOS transistors (422a, 493a, 424a, 495a) are all of a first MOS type, the bipolar transistors (420a, 491a, 428a) are of a first bipolar type, the first MOS type is nMOS when the first bipolar type is npn, and the first MOS type is pMOS when the first bipolar type is pnp.

11. A circuit as in claim 9 further comprising:

a fourth bipolar transistor (420b-2) having a base coupled to the second output terminal ($\overline{V}_{ina}$), a collector coupled to the second rail ($V_{LL}$), and an emitter coupled to the inventing output terminal ($\overline{V}_{out}$)
a fifth bipolar transistor (491b-2) having a base coupled to the fourth output terminal ($\overline{V}_{inb}$), a collector coupled to the second rail ($V_{LL}$), and an emitter coupled to the emitter of the fourth bipolar transistor (420b-2).
a sixth bipolar transistor (428b-2) a base, a collector, coupled to the emitter of the fourth bipolar transistor (420b-2), and an emitter coupled to the first rail ($V_{HH}$);
a fifth MOS transistor (422b-2) having a gate electrode coupled to the first output terminal ($V_{ina}$), a drain, and a source;
a sixth MOS transistor (493b-2) having a gate electrode coupled to the third output terminal ($V_{inb}$), a drain, and a source, the two MOS transistors (422b-2, 493b-2) being arranged in series such that the drain and the source of one are respectively coupled to the emitter of the fourth bipolar transistor (420b-2) and to the drain of the other whose source is coupled to the base of the third pnp transistor;

a seventh MOS transistor (424b-2) having a gate electrode coupled to the second output terminal ($\overline{V}_{ina}$), a drain coupled to the base of the sixth bipolar transistor (428b-2), and a source coupled to the first rail ($V_{HH}$); and
a eighth MOS transistor (495b-2) having a gate electrode coupled to the fourth output terminal ($\overline{V}_{inb}$), a drain coupled to the base of the sixth bipolar transistor (428b-2), and a source coupled to the first rail ($V_{HH}$).

12. A circuit as in claim 11 wherein the first (493b-1), the second (422b-1), the third (424b-1), and the fourth (495b-1) MOS transistors are of a first MOS type; the first (420b-1), the second (428b-1), and the third (491b-1) bipolar transistors are of a first bipolar type; the fifth (422b-2), the sixth (493b-2), the seventh (424b-2), and the eight (495b-2) MOS transistors are of a second MOS type; the fourth (420b-2), the fifth (491b-2), and the sixth (428b-2) bipolar transistors are of a second bipolar type; the first MOS type in nMOS when the first bipolar type is npn, and the first type is pMOS when the first bipolar type is pnp.

13. A circuit as in claim 10 further comprising: circuitry being a duplicate of the circuitry constituted by the first (520a), the second (528a), and the third (591a) bipolar transistors; and the first (593a), the second (522a), the third (524a), and the fourth (595a) MOS transistors; a duplicated non inverting output terminal (Vout') coupled to the emitters of the corresponding bipolar transistors of the duplicated circuitry; and input terminals of the duplicated circuitry, with regard to the non duplicated circuitry, inversely responsive to the non inverting (Voa,Vob) and the inverting ($\overline{V}$oa, $\overline{V}$ob) input terminals

14. A circuit as in claim 13 wherein the MOS transistors are all of a first MOS type, the bipolar transistors are of a first bipolar type, the first MOS type is nMOS when the first bipolar type is npn, and the first MOS type is pMOS when the first bipolar type is pMOS.

**Patentansprüche**

1. Elektronische Schaltung mit: Eingangsmitteln (311) mit einer ersten Ausgangsklemme (Vin) zum Liefern eines ersten Ausgangslogiksignals (Vin) und einer zweiten Ausgangsklemme ($\overline{V}$in) zum Liefern eines zweiten Ausgangslogiksignals ($\overline{V}$in), wobei das erste und das zweite Ausgangslogiksignal (Vin, $\overline{V}$in) komplementär sind; einem ersten Bipolartransistor (320-1) mit einer Basis, die mit der ersten Ausgangsklemme (Vin) der Eingangsmittel (311) gekoppelt ist, einem Kollektor, der mit einer ersten Spannungsreferenzschiene ($V_{HH}$ ) gekoppelt ist, und einem Emitter; einem zweiten Bipolartransistor (328-1) mit einem Kollektor, der mit dem Emitter des ersten Bipolartransistors (320-1) gekoppelt ist, einem Emitter, der mit einer zweiten Spannungsreferenzschiene ($V_{LL}$) gekoppelt ist, und einer Basis; einem ersten MOS-Transistor (322-1) mit einer Drain, einer mit der Basis des zweiten Bipolartransistors (328-1) gekoppelten Source und einem mit der zweiten Ausgangsklemme ($\overline{V}$in) der Eingangsmittel (311) gekoppelten Gate, dadurch gekennzeichnet, dass das Eingangsmittel (3111) weiterhin eine erste Eingangsklemme (Vo) zum Empfangen eines ersten Eingangslogiksignals (Vo) und eine zweite Eingangsklemme ($\overline{V}$o) zum Empfangen eines zweiten Eingangslogiksignals ($\overline{V}$o) umfasst, wobei das erste und das zweite Eingangslogiksignal (Vo, $\overline{V}$o) komplementär sind.

2. Schaltung nach Anspruch 1, dadurch gekennzeichnet, dass die Drain des ersten MOS-Transistors (322-1) mit dem Emitter des ersten Bipolartransistors (320-1) gekoppelt ist.

3. Schaltung nach Anspruch 2, die weiterhin umfasst:

einen dritten Bipolartransistor (320-2) mit einer Basis, die mit der zweiten Ausgangsklemme ($\overline{V}$in) gekoppelt ist, einem Kollektor, der mit der ersten Schiene ($V_{HH}$) gekoppelt ist, und einem Emitter;
einen vierten Bipolartransistor (328-2) mit einer Basis, einem Kollektor, der mit dem Emitter des dritten Bipolartransistors (320-2) gekoppelt ist, und einem Emitter, der mit der zweiten Schiene ($V_{LL}$) gekoppelt ist;
einen zweiten MOS-Transistor (322-2) mit einer Gateelektrode, die mit der ersten Ausgangsklemme (Vin) gekoppelt ist, einer mit dem Emitter des dritten Bipolartransistors gekoppeltem Drain und einer mit der Basis des vierten Bipolartransistors (328-2) gekoppelten Source, wobei der erste und der zweite MOS-Transistor von einem ersten MOS-Typ sind;
einen dritten MOS-Transistor (361-1) mit einer Gateelektrode, die mit einer invertierenden Ausgangsklemme ($\overline{V}$out) der elektronischen Schaltung gekoppelt ist, einer mit der ersten Schiene ($V_{HH}$) gekoppelten Source und einer mit dem Emitter des ersten Bipolartransistors (320-1) gekoppelten Drain und
einen vierten MOS-Transistor (361-2) mit einer Gateelektrode, die mit einer nicht invertierenden Ausgangsklemme (Vout) der elektronischen Schaltung gekoppelt ist, einer mit der ersten Schiene ($V_{HH}$) gekoppelten Source und einem mit dem Emitter des dritten Bipolartransistors (320-2) gekoppelten Drain, wobei der dritte und der vierte MOS-Transistor von einem zweiten, dem ersten MOS-Typ entgegengesetzten MOS-Typ sind, wobei die nicht invertierende Ausgangsklemme (Vout) und die invertierende Ausgangsklemme ($\overline{V}$out) der elektronischen Schaltung mit den Emittern des ersten (320-1) bzw. des dritten (320-2) Bipolartransistors gekoppelt sind.

4. Schaltung nach Anspruch 3, worin die Bipolartransistoren (320-1, 320-2, 328-1, 328-2) von einem ersten Bipolartyp sind, der erste MOS-Typ NMOS ist, wenn der erste Bipolartyp npn ist, und der erste MOS-Typ PMOS ist, wenn der erste Bipolartyp pnp ist.

5. Schaltung nach Anspruch 4, die weiterhin umfasst:

einen fünften MOS-Transistor (324-1) mit einer Gateelektrode, die auf den nicht invertierenden Eingang (Vo) anspricht, einer mit der Source des ersten MOS-Transistors (322-1) gekoppelten Drain und einer mit der zweiten Schiene ($V_{LL}$) gekoppelten Source und
einen sechsten MOS-Transistor (324-2) mit einem mit der ersten Ausgangsklemme (Vin) gekoppelten Gate, einer mit der Source des zweiten MOS-Transistors (322-2) gekoppelten Drain und einer mit der zweiten Schiene ($V_{LL}$) gekoppelten Source, wobei der fünfte und der sechste MOS-Transistor von einem ersten MOS-Typ sind.

6. Schaltung nach Anspruch 1, dadurch gekennzeichnet, dass das Gate des dritten MOS-Transistors (361-1) mit der Source des dritten Bipolartransistors (320-2) gekoppelt ist, das Gate des vierten MOS-Transistors (361-2) mit der Source des ersten Bipolartransistors (320-1) gekoppelt ist, die Gates des ersten (322-1) und des sechsten (324-2) MOS-Transistors mit der Basis des dritten Bipolartransistors (320-2) gekoppelt sind und die Gates des dritten (322-2) und des fünften (324-1) MOS-Transistors mit der Basis des ersten Bipolartransistors (320-1) gekoppelt sind.

7. Schaltung nach Anspruch 6, worin die Bipolartransistoren (320-1, 320-2, 328-1, 328-2) von einem ersten Bipolartyp sind, der erste MOS-Typ NMOS ist, wenn der erste Bipolartyp npn ist, und der erste MOS-Typ PMOS ist, wenn der erste Bipolartyp pnp ist.

8. Schaltung nach Anspruch 1 mit: zweiten Eingangsmitteln (411aB) mit einer dritten Ausgangsklemme (Vinb) zum Liefern eines dritten Ausgangslogiksignals (Vinb) und einer vierten Ausgangsklemme ($\overline{V}$inb) zum Liefern eines vierten Ausgangslogiksignals ($\overline{V}$inb), wobei das dritte und das vierte Aus-

gangslogiksignal (Vinb, $\overline{\text{Vinb}}$) komplementär sind; einer dritten Eingangsklemme (Vob) zum Empfangen eines dritten Eingangslogiksignals (Vob) und einer vierten Eingangsklemme ($\overline{\text{Vob}}$) zum Empfangen eines vierten Eingangslogiksignals ($\overline{\text{Vob}}$), wobei das dritte und das vierte Eingangslogiksignal (Vob, $\overline{\text{Vob}}$) komplementär sind; einem nicht invertierenden Ausgang (Vout), der mit dem Emitter des ersten Bipolartransistors (420a) gekoppelt ist; einem dritten Bipolartransistor (491a) mit einer Basis, die mit der dritten Ausgangsklemme (Vinb) gekoppelt ist, einem Kollektor, der mit dem Kollektor des ersten Bipolartransistors (420a) gekoppelt ist, und einem Emitter, der mit dem Emitter des ersten Bipolartransistors (420a) gekoppelt ist; einem zweiten MOS-Transistor (422a) mit einem Gate, das mit der zweiten Ausgangsklemme ($\overline{\text{Vina}}$) gekoppelt ist, einer mit dem Emitter des ersten Bipolartransistors (420a) gekoppelten Drain und einer Source, wobei das Gate des ersten MOS-Transistors (493a) mit der vierten Ausgangsklemme ($\overline{\text{Vinb}}$) gekoppelt ist und die Drain des ersten MOS-Transistors (493a) mit der Source des zweiten MOS-Transistors (422a) gekoppelt ist.

9. Schaltung nach Anspruch 8, die weiterhin umfasst:

einen dritten MOS-Transistor (424a) mit einer Gateelektrode, die mit der ersten Ausgangsklemme (Vina) gekoppelt ist, einer mit der Basis des zweiten Bipolartransistors (428a) gekoppelten Drain und einer mit der zweiten Schiene ($V_{LL}$) gekoppelten Source und einen vierten MOS-Transistor (495a) mit einer Gateelektrode, die mit der dritten Ausgangsklemme (Vinb) gekoppelt ist, einer mit der Basis des zweiten Bipolartransistors (428a) gekoppelten Drain und einer mit der zweiten Schiene ($V_{LL}$) gekoppelten Source.

10. Schaltung nach Anspruch 9, worin alle MOS-Transistoren (422a, 493a, 424a, 495a) von einem ersten MOS-Typ sind, die Bipolartransistoren (420a, 491a 428a) von einem ersten Bipolartyp sind, wobei der erste MOS-Typ n-MOS ist, wenn der erste Bipolartyp npn ist, und der erste MOS-Typ PMOS ist, wenn der erste Bipolartyp pnp ist.

11. Schaltung nach Anspruch 9, die weiterhin umfasst:

einen vierten Bipolartransistor (420b-2) mit einer Basis, die mit der zweiten Ausgangsklemme ($\overline{\text{Vina}}$) gekoppelt ist, einem Kollektor, der mit der zweiten Schiene ($V_{LL}$) gekoppelt ist, und einem Emitter, der mit der invertierenden Ausgangsklemme ($\overline{\text{Vout}}$) gekoppelt ist; einen fünften Bipolartransistor (491b-2) mit einer Basis, die mit der vierten Ausgangs-

klemme ($\overline{\text{Vinb}}$) gekoppelt ist, einem Kollektor, der mit der zweiten Schiene ($V_{LL}$) gekoppelt ist der, und einem Emitter, der mit dem Emitter des vierten Bipolartransistors (420b-2) gekoppelt ist;

einen sechsten Bipolartransistor (428b-2) mit einer Basis, einem Kollektor, der mit dem Emitter des vierten Bipolartransistors (420b-2) gekoppelt ist, und einem Emitter, der mit der ersten Schiene ($V_{HH}$) gekoppelt ist;

einen fünften MOS-Transistor (422b-2) mit einer Gateelektrode, die mit der ersten Ausgangsklemme (Vina) gekoppelt ist, einer Drain und einer Source;

einen sechsten MOS-Transistor (493b-2) mit einer Gateelektrode, die mit der dritten Ausgangsklemme (Vinb) gekoppelt ist, einer Drain und einer Source, wobei die beiden MOS-Transistoren (422b-2, 493b-2) in Reihe geschaltet sind, so dass die Drain bzw. die Source des einen mit dem Emitter des vierten Bipolartransistors (420b-2) gekoppelt ist bzw. der Drain des anderen, dessen Source mit der Basis des dritten pnp-Transistors gekoppelt ist;

einen siebten MOS-Transistor (424b-2) mit einer Gateelektrode, die mit der zweiten Ausgangsklemme ($\overline{\text{Vina}}$) gekoppelt ist, einer mit der Basis des sechsten Bipolartransistors (428b-2) gekoppelten Drain und einer mit der ersten Schiene ($V_{HH}$) gekoppelten Source und einen achten MOS-Transistor (495b-2) mit einer Gateelektrode, die mit der vierten Ausgangsklemme ($\overline{\text{Vinb}}$) gekoppelt ist, einer mit der Basis des sechsten Bipolartransistors (428b-2) gekoppelten Drain und einer mit der ersten Schiene ($V_{HH}$) gekoppelten Source.

12. Schaltung nach Anspruch 11, worin der erste (493b-1), der zweite (422b-1), der dritte (424b-1) und der vierte (495b-1) MOS-Transistor von einem ersten MOS-Typ sind; der erste (420b-1), der zweite (428b-1) und der dritte (491b-1) Bipolartransistor von einem ersten Bipolartyp sind; der fünfte (422b-2), der sechste (493b-2), der siebte (424b-2) und der achte (495b-2) MOS-Transistor von einem zweiten MOS-Typ sind; der vierte (420b-2), der fünfte (491b-2) und der sechste (428b-2) Bipolartransistor von einem zweiten Bipolartyp sind; der erste MOS-Typ NMOS ist, wenn der erste Bipolartyp npn ist, und der erste MOS-Typ PMOS ist, wenn der erste Bipolartyp pnp ist.

13. Schaltung nach Anspruch 10, die weiterhin umfasst: eine Schaltungsgesamtheit, die ein Duplikat der vom ersten (520a), zweiten (528a) und dritten (591a) Bipolartransistor und dem ersten (593a), dem zweiten (522a), dem dritten (524a) und dem vierten (595a) MOS-Transistor gebildeten Schaltungsgesamtheit ist; eine duplizierte nicht invertierende Ausgangsklemme (Vout'), die mit den Emittern der entsprechenden Bipolartransistoren der duplizierten Schaltungsgesamtheit gekoppelt ist, und Eingangsklemmen der duplizierten Schaltungsgesamtheit, die bezüglich der nicht duplizierten Schaltungsgesamtheit invers auf die nicht invertierenden (Voa, Vob) und die invertierenden ($\overline{V}$oa $\overline{V}$ob) Eingangsklemmen ansprechen.

14. Schaltung nach Anspruch 13, worin alle MOS-Transistoren von einem ersten MOS-Typ sind, die Bipolartransistoren von einem ersten Bipolartyp sind, der erste MOS-Typ n-MOS ist, wenn der erste Bipolartyp npn ist, und der erste MOS-Typ PMOS ist, wenn der erste Bipolartyp pnp ist.

**Revendications**

1. Circuit électronique comprenant : des moyens d'entrée (311) munis d'une première borne de sortie (Vin) pour fournir un premier signal de sortie logique (Vin) et d'une deuxième borne de sortie ($\overline{V}$in) pour fournir un deuxième signal de sortie logique ($\overline{V}$in) , les premier et deuxième signaux de sortie logiques (Vin, $\overline{V}$in) étant complémentaires; un premier transistor bipolaire (320 - 1) présentant une base couplée à la première borne de sortie (Vin) des moyens d'entrée (311), un collecteur couplé à un premier rail de tension de référence ($V_{HH}$) et un émetteur; un deuxième transistor bipolaire (328 - 1) présentant un collecteur couplé à l'émetteur du premier transistor bipolaire (320 - 1), un émetteur couplé à un deuxième rail de tension de référence ($V_{LL}$) et une base; un premier transistor MOS (322 - 1) présentant un drain, une source couplée à la base du deuxième transistor bipolaire (328 - 1) et une porte couplée à la deuxième borne de sortie ($\overline{V}$in) des moyens d'entrée (311), caractérisé ai ce que les moyens d'entrée (311) sont en outre munis d'une première borne d'entrée (Vo) pour la réception d'un premier signal d'entrée logique (Vo) et d'une deuxième borne d'entrée ($\overline{V}$o) pour la réception d'un deuxième signal d'entrée logique $\overline{V}$o, les premier et les deuxième signaux d'entrée logiques (Vo, $\overline{V}$o) étant complémentaires.

2. Circuit selon la revendication 1, caractérisé en ce que le drain du premier transistor MOS (322 - 1) est couplé à l'émetteur du premier transistor bipolaire (320 - 1).

3. Circuit selon la revendication 2, comprenant en outre:

   un troisième transistor bipolaire (320-2) présentant une base couplée à la deuxième borne d'entrée ($\overline{V}$in), un collecteur couplé au premier rail $V_{HH}$ et un émetteur;
   un quatrième transistor bipolaire (328 -2) présentant une base, un collecteur bipolaire couplé à l'émetteur du troisième transistor bipolaire (320 - 2) et un émetteur couplé au deuxième rail ($V_{LL}$);
   un deuxième transistor MOS (322 - 2) présentant une électrode de porte couplée à la première borne de sortie (Vin), un drain couplé à l'émetteur du troisième transistor bipolaire (320 - 2) et une source couplée à la base du quatrième transistor bipolaire (328 - 2), les première et deuxième transistors MOS étant d'un premier type MOS;
   un troisième transistor MOS (361 - 1) présentant une électrode de porte couplée à une borne de sortie inverseuse ($\overline{V}_{out}$) du circuit électronique , une source couplée au premier rail ($V_{HH}$ ) et un drain couplé à l'émetteur du premier transistor bipolaire (320- 1); et
   un quatrième transistor MOS (361 - 2) présentant une électrode de porte couplée à une borne de sortie non inverseuse ($V_{out}$) du circuit électronique, une source couplée au premier rail ($V_{HH}$) et un drain couplé à l'émetteur du troisième transistor bipolaire (320 - 2), les troisième et quatrième transistors MOS étant d'un deuxième type MOS qui est opposé au premier type MOS, la borne de sortie non inverseuse ($V_{out}$) et la borne de sortie inverseuse ($\overline{V}$out) du circuit électronique étant couplées respectivement aux émetteurs du premier (320 - 1) et troisième (320-2) transistors bipolaires.

4. Circuit selon la revendication 3, dans lequel les transistors bipolaires (320 - 1, 320 - 2, 328 - 1, 328 -2) sont d'un premier type bipolaire, le premier type MOS est nMOS lorsque le premier type bipolaire est npn et le premier type MOS est pMOS lorsque le premier type bipolaire est pnp.

5. Circuit selon la revendication 4 comprenant en outre:

   un cinquième transistor MOS (324 - 1) présentant une électrode de porte répondant à l'entrée non inverseuse (Vo), un drain couplé à la source du premier transistor MOS (322 - 1) et une source couplée au deuxième rail ($V_{LL}$); et
   un sixième transistor MOS (324-2) présentant une porte couplée à la première borne d'entrée (Vin), un drain couplé à la source du deuxième transistor MOS (322 -2) et une source couplée au deuxième rail ($V_{LL}$), les cinquième et sixième transistors MOS étant du premier type MOS.

6. Circuit selon la revendication 5, caractérisé en ce que la porte du troisième transistor MOS (361 - 1) est couplée à la source du troisième transistor bipolaire (320 - 2), la porte du quatrième transistor MOS (361 - 2) est couplée à la source du premier transistor bipolaire (320 - 1), les portes des premier (322 - 1) et sixième (324 - 2) transistors MOS sont couplées à la base du troisième transistor bipolaire (320 - 2); et les portes des troisième (322 -2) et cinquième (324 - 1) transistors MOS sont couplées à la base du premier transistor bipolaire (320 - 1).

7. Circuit selon la revendication 6, dans lequel les transistors bipolaires (320 - 1, 320 - 2, 328 - 1, 328 - 2) sont d'un premier type bipolaire, le premier type MOS est nMOS lorsque le premier type bipolaire est npn et le premier type MOS est pMOS lorsque le premier type bipolaire est npn.

8. Circuit selon la revendication 1 comprenant: des deuxièmes moyens d'entrée (411aB) présentant une troisième borne de sortie (Vinb) pour fournir un troisième signal de sortie logique (Vinb) et une quatrième borne de sortie ($\overline{V}$inb) pour fournir un quatrième signal de sortie ($\overline{V}$inb), les troisième et quatrième signaux de sortie logiques (Vinb, $\overline{V}$inb) étant complémentaires; une troisième borne d'entrée (Vob) pour la réception d'un troisième signal d'entrée logique (Vob) et une quatrième borne d'entrée ($\overline{V}$ob) pour la réception d'un quatrième signal d'entrée logique ($\overline{V}$ob), les troisième et quatrième signaux d'entrée logiques (Vob, $\overline{V}$ob) étant complémentaires; une sortie non inverseuse (Vout) couplée à l'émetteur du premier transistor bipolaire (420a); un troisième transistor bipolaire (491a) présentant une base couplée à la troisième borne de sortie (Vinb), un collecteur couplé au collecteur du premier transistor bipolaire (420a) et un émetteur couplé à l'émetteur du premier transistor bipolaire (420a); un deuxième transistor MOS (422a) présentant une porte couplée à la deuxième borne de sortie ($\overline{V}$ina), un drain couplé à l'émetteur du premier transistor bipolaire (420a) et une source; et que la porte du premier transistor MOS (493a) est couplée à la quatrième borne de sortie ($\overline{V}$inb) et le drain du premier transistor MOS (493a) est couplé à la source du deuxième transistor MOS (422a).

9. Circuit selon la revendication 8, comprenant en outre:

un troisième transistor MOS (424a) présentant une électrode de porte couplée à la première borne de sortie (Vina), un drain couplé à la base du deuxième transistor bipolaire (428a) et une source couplée au deuxième rail (V$_{LL}$); et un quatrième transistor MOS (495a) présentant une électrode de porte couplée à la troisième borne de sortie (Vinb), un drain couplé à la base du deuxième transistor bipolaire (428a) et une source couplée au deuxième rail (V$_{LL}$).

10. Circuit selon la revendication 9 dans lequel les transistors MOS (422a, 493a, 424a, 495a) sont tous du premier type MOS, les transistors bipolaires (420a, 491a, 428a) sont d'un premier type bipolaire, le premier type MOS est nMOS lorsque le premier type bipolaire est npn et le premier type MOS est pMOS lorsque le premier type bipolaire est pnp.

11. Circuit selon la revendication 9 comprenant en outre:

un quatrième transistor bipolaire (420b - 2) présentant une base couplée à la deuxième borne de sortie ($\overline{V}$ina), un collecteur couplé au deuxième rail V$_{LL}$ et un émetteur couplé à la borne de sortie inverseuse ($\overline{V}$out); un cinquième transistor bipolaire (491b - 2) présentant une base couplée à la quatrième borne de sortie ($\overline{V}$inb), un collecteur couplé au deuxième rail (V$_{LL}$), et un émetteur couplé à l'émetteur du quatrième transistor bipolaire (420b - 2); un sixième transistor bipolaire (428b -2) présentant une base, un collecteur, couplé à l'émetteur du quatrième transistor bipolaire (420b -2) et un émetteur couplé au premier rail V$_{HH}$; un cinquième transistor MOS (422b -2) présentant une électrode de porte couplée à la première borne de sortie (Vina), un drain et une source; un sixième transistor MOS (493b -2) présentant une électrode de porte couplée à la troisième borne de sortie (Vinb), un drain et une source, les deux transistors MOS (422b -2, 493b -2) étant disposés en série de façon que le drain et la source de l'un de ces deux soient couplés respectivement à l'émetteur du quatrième transistor bipolaire (420b - 2) et au drain de l'autre, dont la source est couplée à la base du troisième transistor pnp; un septième transistor MOS (424b - 2) présentant une électrode de porte couplée à la deuxième borne de sortie ($\overline{V}$ina), un drain couplé à la base du sixième transistor bipolaire (428b - 2) et une source couplée au premier rail V$_{HH}$; et un huitième transistor MOS (495b -2) présentant une électrode de porte couplée à la quatrième borne de sortie ($\overline{V}$inb), un drain couplé à la base du sixième transistor bipolaire (428b - 2) et une source couplée au premier rail (V$_{HH}$).

**12.** Circuit selon la revendication 11, dans lequel les premier (493b - 1), deuxième (422b - 1), troisième (424b - 1) et quatrième (495b - 1) transistors MOS sont d'un premier type MOS; les premier (420b - 1), deuxième (428b - 1) et troisième (491b - 1) transistors bipolaires sont d'un premier type bipolaire; les cinquième (422b - 2), sixième (493b - 2), septième (424b -2) et huitième (495 -2) transistors MOS sont d'un deuxième type MOS; les quatrième (420b - 2), cinquième (491b -2) et sixième (428b -2) transistors bipolaires sont d'un deuxième type bipolaire; le premier type MOS est nMOS lorsque le premier type bipolaire est npn et le premier type MOS est pMOS lorsque le premier type bipolaire est pnp.

**13.** Circuit selon la revendication comprenant en outre: des circuits constituant des copies des circuits constitués par les premier (520a), deuxième (528a) et troisième (591a) transistors bipolaires; et les premier (593a), deuxième (522a), troisième (524a) et quatrième (595a) transistors MOS; une borne de sortie non inverseuse copiée (Vout') couplée aux émetteurs des transistors bipolaires correspondants des circuits copiés; et des bornes d'entrée des circuits copiés qui, en ce qui concerne les circuits copiés, sont inversément sensibles aux bornes d'entrée non inverseuses (Va, Vob) et inverseuses ( $\overline{V}$oa, $\overline{V}$ob).

**14.** Circuit selon la revendication 13, dans lequel les transistors MOS sont tous d'un premier type MOS, les transistors bipolaires sont d'un premier type bipolaire, le premier type MOS est nMOS lorsque le premier type bipolaire est npn et le premier type MOS est pMOS lorsque le premier type bipolaire est pMOS.

FIG.1

**FIG.2**

**FIG.3**

FIG.4a

FIG.4b

FIG.5